(19) Europäisches Patentamt
European Patent Office
Office européen des brevets

(11) **EP 2 019 398 B1**

(12) **EUROPEAN PATENT SPECIFICATION**

(45) Date of publication and mention
of the grant of the patent:
**16.05.2012 Bulletin 2012/20**

(51) Int Cl.:
***H01G 9/20*** (2006.01)

(21) Application number: **08004116.3**

(22) Date of filing: **05.03.2008**

(54) **Photo-electrode for dye-sensitized solar cell comprising hollow spherical agglomerates of metal oxide nanoparticles and process for preparation thereof**

Lichtelektrode für eine farbstoffsensibilisierte Solarzelle mit hohlen kugelförmigen Agglomeraten aus Metalloxid-Nanoteilchen und Herstellungsverfahren dafür

Photo-électrode pour pile solaire sensibilisée aux colorants comportant des agglomérations sphériques creuses de nanoparticules d'oxyde métallique, et son procédé de préparation

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **24.07.2007 KR 20070073898**

(43) Date of publication of application:
**28.01.2009 Bulletin 2009/05**

(73) Proprietor: **Korea Institute of Science and Technology**
**Seoul 136-791 (KR)**

(72) Inventors:
• **Kim, Kyung Kon**
**Seongbuk-gu**
**Seoul 136-791 (KR)**

• **Park, Nam-Gyu**
**Yangcheon-gu**
**Seoul 158-759 (KR)**
• **Koo, Hyung Jun**
**Cary, NC 27518 (US)**
• **Lee, Wan In**
**Yeongdeungpo-gu**
**Seoul 150-775 (KR)**
• **Kim, Yong Joo**
**Nam-gu**
**Incheon 402-818 (KR)**

(74) Representative: **Grünberg, Thomas et al**
**Advotec.**
**Patent- und Rechtsanwälte**
**Widenmayerstraße 4**
**80538 München (DE)**

(56) References cited:
**JP-A- 2001 076 772     US-A1- 2004 226 602**

**Description**

**Field of the Invention**

The present invention relates to a photo-electrode for a dye-sensitized solar cell comprising hollow spherical agglomerates of metal oxide nanoparticles for providing improved photoelectric conversion efficiency; and a process for the preparation thereof.

**Background of the Invention**

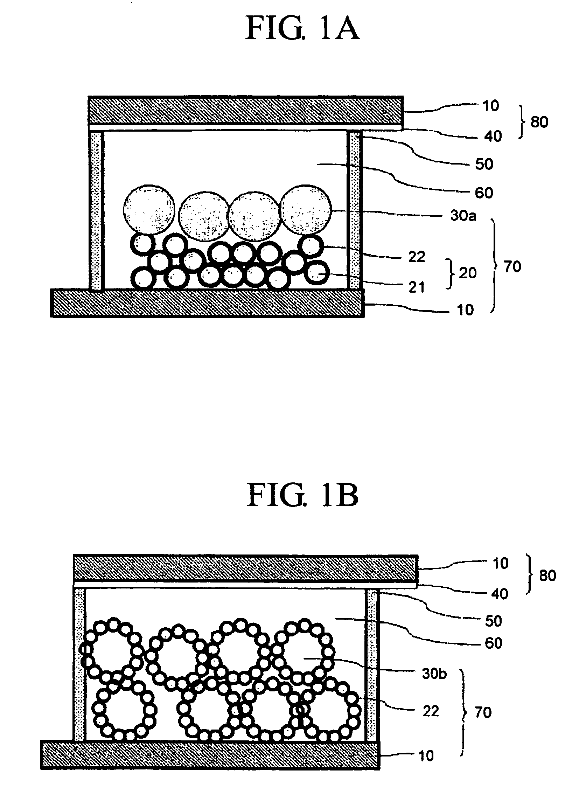

The dye-sensitized solar cell reported by Gratzel et al. of Switzerland in 1991 comprises, as shown in FIG. 1A, a photo-electrode (70), a counter electrode (80) and an electrolyte (60), wherein the photo-electrode (70) comprises a transparent conductive substrate (10), metal oxide nanoparticles (21) having a wide energy bandgap and a photosensitive dye (22) adsorbed thereon, and the counter electrode (80) comprises a transparent conductive substrate (10) having a platinum (Pt) layer (40) coated thereon.

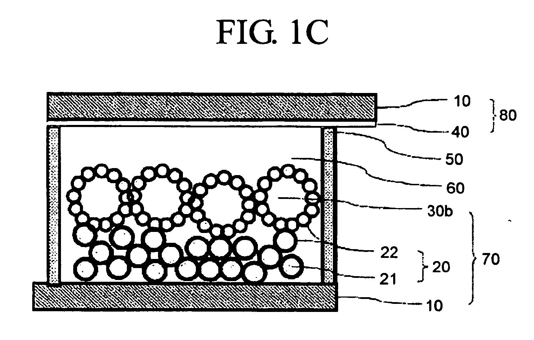

The dye-sensitized solar cell initially proposed by Gratzel et al. did not comprise a light scattering layer, and therefore, to maximize the absorption of the incident light, the light absorbing layer had to be made thick. However, the increased resistance with the thickness of the light absorbing layer leads to the lowering of the absorption efficiency. In order to solve this problem, a light scattering layer (30a) (*see* FIG. 1) is installed over the light absorbing layer (20), so that the light scattering layer (30a) can scatter unabsorbed light back to the light absorbing layer (20) and improve the absorption efficiency. Thus, many attempts have been made to develop various light scattering layers, but the performance characteristics of the reported light scattering layers have proved to be not entirely satisfactory.

From document US 2004/0226602 A1, a dye sensitized solar cell is known which comprises a first layer of nanoporous particles and a second layer of nanoporous particles. The second layer is light scattering layer. A dye is provided on the particles.

From document JP 2001076772 A, a dye sensitized solar cell is known wherein a porous oxide semiconductor layer has a structure which is connected with a plurality of hollow grains having shells on oxide semiconductor fine grains.

**Summary of the Invention**

Accordingly, it is an object of the present invention to provide a photo-electrode having an improved light scattering layer for a dye-sensitized solar cell, said light scattering layer comprising hollow spherical agglomerates of metal oxide nanoparticles which are capable of creating more photoelectrons due to its enhanced light scattering and light absorbing abilities; and a process for the preparation thereof.

In accordance with one aspect of the present invention, there is provided a photo-electrode for a dye-sensitized solar cell comprising a conductive substrate; a light absorbing porous film comprising nanoparticles of a first metal oxide, which is formed on the conductive substrate; a light scattering porous film comprising hollow spherical agglomerates of nanoparticles of a second metal oxide, which is formed on the light absorbing porous film; and a photosensitive dye adsorbed on the surface of the light absorbing metal oxide nanoparticles as well as on the surface of the hollow spherical agglomerates of the light scattering porous film.

In accordance with another aspect of the present invention, there is provided a process for preparing a photo-electrode for a dye-sensitized solar cell comprising (a) forming a light absorbing porous film comprising nanoparticles of a first metal oxide on the surface of a conductive substrate; (b) forming a light scattering porous film comprising hollow spherical agglomerates of nanoparticles of a second metal oxide on the light absorbing porous film; and (c) depositing a photosensitive dye on the surfaces of the light absorbing porous film and the light scattering porous film using an adsorption method.

It is another object of the present invention to provide a dye-sensitized solar cell comprising said photo-electrode.

**Brief Description of the Drawings**

The above and other objects and features of the present invention will become apparent from the following description of the invention, when taken in conjunction with the accompanying drawings, which respectively show:

FIG 1: (A) a cross sectional view of a conventional dye-sensitized solar cell, (B) a cross sectional view of the dye-sensitized solar cell prepared in Comparative Example 1, and (C) a cross sectional view of the inventive dye-sensitized solar cell prepared in Example 1;

FIG 2: (A) a scanning electron microscopic (SEM) image of the surface of the hollow spherical agglomerates of metal oxide nanoparticles in accordance with the present invention, and (B) a scanning electron microscopic image of the cut side of the photo-electrode comprising the hollow spherical agglomerates of metal oxide nanoparticles in accordance with the present invention;

FIG. 3: light scattering effects observed for the dye-sensitized solar cells of Example 1, Comparative Example 4 and the existing solar cell; and

FIG. 4: an X-ray diffraction scan obtained for the hollow spherical agglomerates of metal oxide nanoparticles in accordance with one embodiment of the present invention.

## Detailed Description of the Invention

In accordance with one embodiment of the present invention, a photo-electrode for a dye-sensitized solar cell is provided by a process comprising applying nanoparticles of a first metal oxide over a transparent conductive substrate to form a light absorbing porous film, preparing a hollow spherical agglomerate of nanoparticles of a second metal oxide (hereinafter, abbreviated as "hollow sphere") and then adding thereto a polymeric binder and an organic solvent to prepare a paste, applying the resulting paste over the light absorbing porous film to form a light scattering porous film, subjecting the light absorbing/scattering porous films to heat treatment, and depositing a photosensitive dye on the surfaces of the light absorbing/scattering porous films.

Hereinafter, preferred embodiments of the present invention will be described in detail with reference to the accompanying drawings.

## 1. Preparation of Hollow Spheres

Hollow spheres (30b) are prepared according to a method disclosed in Korean Patent No. 0575843. The second metal oxide used in the preparation of the hollow spheres may be selected from the group consisting of titanium (Ti) oxide, zirconium (Zr) oxide, strontium (Sr) oxide, zinc (Zn) oxide, indium (In) oxide, lanthanum (La) oxide, vanadium (V) oxide, molybdenum (Mo) oxide, tungsten (W) oxide, tin (Sn) oxide, niobium (Nb) oxide, magnesium (Mg) oxide, aluminum (Al) oxide, yttrium (Y) oxide, scandium (Sc) oxide, samarium (Sm) oxide, gallium (Ga) oxide, strontium-titanium (SrTi) oxide, and a mixture thereof.

Preferably, the second metal oxide nanoparticles of hollow spheres have an average particle size ranging from 1 to 500 nm, preferably 5 to 100 nm, and the hollow spheres, an average diameter ranging from 100 to 5,000 nm.

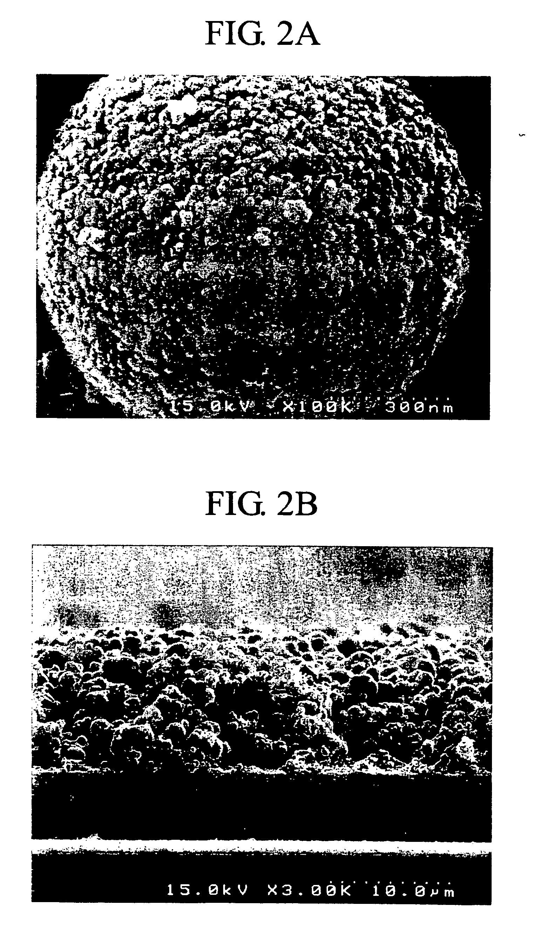

FIG 2A shows a scanning electron microscopic image of the surface of the hollow spheres obtained in accordance with one embodiment of the present invention. As shown in this image, titanium oxide nanoparticles having an average particle size of about 20 nm are self-assembled to form a large hollow spherical agglomerate with a diameter of about 1 $\mu$m.

## 2. Preparation of Hollow Sphere Paste

The hollow spheres thus obtained are mixed with a solvent to produce a colloidal solution, which is then mixed with a binder resin. Then, the resulting mixture may be concentrated using a Rotor Evaporator, for example at a temperature of 40 to 70°C for 30 minutes to 1 hour to remove the solvent, producing a paste containing hollow spheres.

The binder resin may be any of those known in the art, and is preferably a polymer which does not leave organic residues after heat treatment, such as polyethylene glycol (PEG), polyethylene oxide (PEO), polyvinyl alcohol (PVA), polyvinyl pyrrolidone (PVP), and ethyl cellulose. Further, the hollow sphere paste thus obtained may be dispersed once more using a three-roll mill in order to obtain a more homogeneous dispersion.

Any solvent that may be used in preparing a colloidal solution can be used in this invention, and it includes, for example, ethanol, methanol, terpineol, lauric acid, tetrahydrofuran (THF), and water.

In this invention, one preferred embodiment of the hollow sphere paste composition comprises titanium oxide, lauric acid, terpineol and ethyl cellulose; or titanium oxide, ethanol, and ethyl cellulose. In this case, the mixing ratio of the binder resin, the solvent and the hollow sphere is not particularly limited in this invention, and ethyl cellulose, lauric acid, terpineol and hollow sphere may be mixed at a weight ratio of 1:2-6:0.2-0.5:0.05-0.3.

## 3. Preparation of Photo-electrode for Dye-sensitized Solar Cell Comprising Hollow Spheres in Light Scattering Porous Film

The structure of dye-sensitized solar cell comprising a light scattering layer made of the hollow spheres is illustrated in FIG 1C.

[Preparation of Metal Oxide Nanoparticle Paste]

The nanoparticles of the first metal oxide for forming light absorbing porous film can be synthesized by hydrothermal reaction, but commercially available metal oxide nanoparticles may be also used in this invention. The metal oxide nanoparticles are mixed with a solvent to produce a colloidal solution having a viscosity ranging from $5 \times 10^4$ to $5 \times 10^5$. centipoises (cps) (50 Pa·s to 500 Pa·s), which is then mixed with a binder resin. Then, the resulting mixture may be concentrated using a Rotor Evaporator, for example at a temperature of 40 to 70°C for 30 minutes to 1 hour, to remove the solvent, producing a paste containing metal oxide nanoparticles.

The binder resin may be any of those known in the art, and is preferably a polymer which does not leave organic residues after heat treatment, such as polyethylene glycol (PEG), polyethylene oxide (PEO), polyvinyl alcohol (PVA), polyvinyl pyrrolidone (PVP), and ethyl cellulose. Further, the metal oxide nanoparticle paste thus obtained may be dispersed once more using a three-roll mill in order to obtain a more homogeneous dispersion.

The first metal oxide used in the preparation of nanoparticle, which may be the same as the second metal oxide used in the preparation of hollow spheres, may be selected from the group consisting of titanium (Ti) oxide, zirconium (Zr) oxide, strontium (Sr) oxide, zinc (Zn) oxide, indium (In) oxide, lanthanum (La) oxide, vanadium (V) oxide, molybdenum (Mo) oxide, tungsten (W) oxide, tin (Sn) oxide, niobium (Nb) oxide, magnesium (Mg) oxide, aluminum (Al) oxide, yttrium (Y) oxide, scandium (Sc) oxide, samarium (Sm) oxide, gallium (Ga) oxide, strontium-titanium (SrTi) oxide, and a mixture thereof. More preferably, the first metal oxide may be selected from the group consisting of titanium oxide ($TiO_2$), zinc oxide (ZnO), tin oxide ($SnO_2$), and tungsten oxide ($WO_3$).

Preferably, the first metal oxide nanoparticles have an average particle size of less than 500 nm, more preferably from 1 to 100 nm.

The organic solvent that may be used in producing a colloidal solution includes ethanol, methanol, terpineol, lauric acid, tetrahydrofuran (THF), and water.

In this invention, one preferred embodiment of the first metal oxide nanoparticle paste composition comprises titanium oxide, lauric acid, terpineol and ethyl cellulose; or titanium oxide, ethanol and ethyl cellulose. In this case, the mixing ratio of the metal oxide nanoparticle, the binder resin and the solvent is not particularly limited in this invention, and ethyl cellulose, lauric acid, terpineol and metal oxide nanoparticles may be mixed at a weight ratio of 1:2-6:0.2-0.5: 0.05-0.3.

[Formation of Light Absorbing Porous Film]

The first metal oxide nanoparticle paste thus obtained is applied on a transparent conductive substrate (10), which is then subjected to heat treatment, for example at a high temperature of 450 to 500°C for about 30 minutes in the air or an oxygen atmosphere, to produce the light absorbing porous film comprising first metal oxide nanoparticles.

The transparent conductive substrate may be any of those used in the art, e.g., a transparent plastic substrate, such as polyethylene terephthalate (PET), polyethylene naphthalate (PEN), polycarbonate (PC), polypropylene (PP), polyimide (PI), triacethyl cellulose (TAC), etc.; or a glass substrate having a conductive film, such as indium tin oxide (ITO), fluorine tin oxide (FTO), $ZnO\text{-}Ga_2O_3$, $ZnO\text{-}Al_2O_3$, $SnO_2\text{-}Sb_2O_3$, etc., coated thereon.

[Formation of Light Scattering Porous Film]

The hollow sphere paste previously obtained is applied over the light absorbing porous film (21) thus formed using a doctor blade, and then subjected to heat treatment, for example at a high temperature of 450 to 500°C for about 30 minutes in the air or an oxygen atmosphere to produce the inventive light scattering porous film comprising the hollow spheres (30b).

Preferably, the average thickness of the light scattering porous film comprising the hollow spheres is in the range of 10 nm to 4 $\mu$m. It is highly preferred to set the thickness of the light scattering porous film to said range for achieving the desired photoelectron generation and photo-scattering efficiencies.

[Adsorption of Photosensitive Dye]

The photosensitive dye is then coated on the surface of the light absorbing porous film as well as on the surface of the light scattering porous film. The photosensitive dye that may be used in the present invention is a ruthenium (Ru) compound, e.g., Ru(4,4'-dicarboxy-2,2'-bipyridine)$_2$(NCS)$_2$, or any material capable of absorbing visible light. The dye coating may be carried out by dye adsorption in the preparation of the dye-sensitized solar cells. For example, a photo-electrode having porous metal oxide films is immersed in a solution containing a photosensitive dye for over a period of about 12 hours, to allow the photosensitive dye to adsorb on the surface of the porous metal oxide films. The solvent for dissolving the dye is not particularly limited in the present invention, but preferred is acetonitrile, dichloromethane, or an alcohol. After the adsorption of the dye, the treated substrate may be washed with a solvent to remove unadsorbed dye.

### 4. Completion of Dye-sensitized Solar Cell

FIG 1C illustrates a schematic view of the inventive dye-sensitized solar cell prepared in Example 1, which comprises the photo-electrode (70) described previously, a counter electrode (80) disposed opposite to the photo-electrode (70), an electrolyte (60) introduced to the space between the two electrodes, and adhesive epoxy resin layers (50) encasing the cell.

The electrolyte (60) is uniformly dispersed between the photo-electrode (70) and the counter electrode (80) inclusive of the pores of the light absorbing porous film (20) and the light scattering porous film (30b).

The dye-sensitized solar cell according to the present invention comprises the photo-electrode (70) formed on a transparent conductive substrate (10), and the counter electrode (80) and the electrolyte (60) may be of any kinds that are available in the art. For example, the counter electrode (80) may comprise a platinum layer or a carbonaceous layer on a conductive substrate (10), while the electrolyte (60) may comprise an iodide/triodide pair that receives an electron from the counter electrode (80) by oxidation and reduction and transfers the electron to the dye (22) of the photo-electrode (70).

The following Examples and Comparative Examples are given for the purpose of illustration only, and are not intended to limit the scope of the invention.

Preparation Example 1

Hollow spherical agglomerates of titanium oxide nanoparticles (also referred to as "hollow sphere"), having a mean diameter of 1 to 2 $\mu$m, were fabricated according to the method disclosed in Korea Patent No. 10-0575843.

2 mmol of titanium isopropoxide (97%, Aldrich Chemical Co.) was dissolved in 20 ml of ethanol, 4 mmol of TBAH (tetra-butyl ammonium hydroxide in the form of a 40% solution obtained from Aldrich Chemical Co.) was added slowly thereto with stirring for about 10 minutes to adjust the molar ratio of Ti to TBAH was 1:2. The resulting clear solution was then subjected to a solvothermal reaction at 240°C for 6 hours in a highpressure reactor, during which ultra-fined white titania nanoparticles having the anatase crystalline form were self-assembled to form a hollow sphere having a mean diameter of 1 to 2 $\mu$m. The yield of the hollow sphere titania nanoparticles was 1.6g.

Comparative Example 1: Preparing a photo-electrode containing titania Hollow spheres in the light absorbing layer; and a solar cell constructed therewith

Instead of the conventional light scattering particles, the hollow spheres obtained in Preparation Example 1 were employed in forming a light absorbing layer in a photo-electrode to assess its capability in enhancing the photocurrent.

(Production of Photo-electrode)

An FTO (fluorine-doped tin oxide) coated glass substrate was prepared. An area of 1.5 cm$^2$ of the conductive surface thereof was masked using an adhesive tape.

Then, a metal oxide nanoparticle paste comprising the hollow sphere particles obtained in Preparation Example 1, a polymer binder (ethyl cellulose) and an organic solvent (terpineol) was applied over the coated substrate with a doctor blade, and subjected to heat treatment at 500°C for 15 minutes to form a porous film having a thickness of 9.8 $\mu$m. The above mentioned metal oxide nanoparticle paste contained ethyl cellulose, lauric acid, terpineol, and hollow sphere particles in a weight ratio of 1:4:0.3:0.1.

The coated substrate thus obtained was dipped in 0.3 mM [Ru(4,4'-dicarboxy-2,2'-bipyridine)$_2$(NCS)$_2$] in ethanol for 12 hours to let the ruthenium complex adsorb on the surface of the porous film.

(Production of Counter Electrode)

An FTO coated glass substrate was prepared, and an area of 1.5 cm$^2$ of the conductive surface thereof was masked using an adhesive tape, and a solution of $H_2PtCl_6$ was coated thereon by spin coating. After the adhesive tape was removed, the substrate was subjected to heat treatment at 500°C for 30 minutes to produce a counter electrode.

(Injection of Electrolyte and Sealing)

An acetonitrile electrolyte solution containing LiI (0.5 M) and I (0.05 M) was injected into the space between the photo-electrode and the counter electrode obtained above, and the resulting assembly was sealed using an adhesive epoxy resin to produce a dye-sensitized solar cell, as depicted in FIG 1B.

Comparative Example 2

In order to assess the ability of the hollow sphere particles obtained in Preparation Example 1 in enhancing the generation of the photocurrent in addition to its improved light scattering effect, a dye-sensitized solar cell was manufactured using the procedure of Comparative Example 1 except that conventional light scattering particles (titanium oxide nanoparticles having a mean particle size of 400 nm) were employed in forming the light absorbing layer in place of the hollow sphere particles.

Example 1: Photo-electrode comprising hollow sphere particles in the light scattering layer

(Production of Photo-electrode)

An FTO coated glass substrate was prepared, and an area of 1.5 cm$^2$ of the conductive surface thereof was masked using an adhesive tape.

Then, a metal oxide nanoparticle paste composed of titanium oxide nanoparticles (mean particle size: 20 nm), a polymer binder (ethyl cellulose) and an organic solvent (terpineol) was applied on the masked surface of the substrate with a doctor blade, and subjected to heat treatment at 500°C for 15 minutes to form a light absorbing porous film comprising metal oxide nanoparticles having a thickness of 150 to 200 nm. The above mentioned metal oxide nanoparticle paste contained ethyl cellulose, lauric acid, terpineol, and titanium oxide nanoparticle in a weight ratio of 1:4:0.3:0.1.

Then, a hollow sphere paste comprising the hollow spheres obtained in Preparation Example 1, a polymer binder (ethyl cellulose) and an organic solvent (terpineol) was applied over the light scattering porous film obtained above with a doctor blade, and subjected to heat treatment at 500°C for 15 minutes to form a light scattering porous film having a thickness of 150 to 200 nm. The above mentioned hollow sphere paste contained ethyl cellulose, lauric acid, terpineol, and hollow sphere particles in a weight ratio of 1:4:0.3:0.1.

The resulting assembly was then dipped in 0.3 mM [Ru(4,4'-dicarboxy-2,2'-bipyridine)$_2$(NCS)$_2$] in ethanol for 12 hours to let the ruthenium complex adsorb on the surface of the light absorbing porous film as well as on the surface of the light scattering porous film, to obtain a photo-electrode.

(Production of Counter Electrode)

An FTO coated glass substrate was prepared, and an area of 1.5 cm$^2$ of the conductive surface thereof was masked using an adhesive tape, and a solution of H$_2$PtCl$_6$ was spin-coated thereon. After the adhesive tape was removed, the substrate was subjected to heat treatment at 500°C for 30 minutes to produce a counter electrode.

(Injection of Electrolyte and Sealing)

An acetonitrile electrolyte solution containing LiI (0.5 M) and I (0.05 M) was injected into the space between the photo-electrode and the counter electrode obtained above and the resulting assembly was sealed using an adhesive epoxy resin to obtain a dye-sensitized solar cell, which is depicted in FIG 1C.

Comparative Example 3

A dye-sensitized solar cell was manufactured by the procedure of Example 1 except that the light scattering layer was not formed during the production of a photo-electrode.

Comparative Example 4

A dye-sensitized solar cell was manufactured by the procedure of Example 1 except that commercially available titanium oxide nanoparticles having a mean particle size of 400 nm were used in place of the hollow sphere particles in forming the light scattering layer.

Test Example 1

The surface of the hollow sphere particles obtained in Preparation Example 1, and the surface of the dissected section thereof were observed with a scanning electron microscope (SEM). The results are shown in FIGS. 2A and 2B, respectively.

Test Example 2

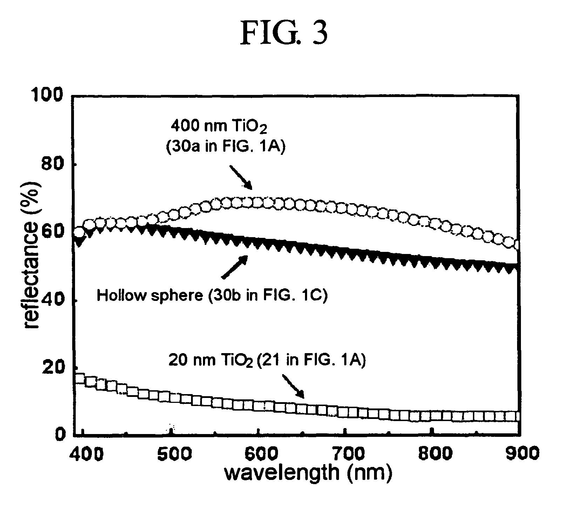

The reflectance of the light scattering layer containing the hollow spheres obtained in Example 1 (30b of FIG 1C) was compared with that of conventional light scattering layer containing the titanium oxide nanoparticles. (mean particle size: 400 nm) obtained in Comparative Example 4 (30a of FIG 1A) which was combined with the light absorbing layer (21 of FIG. 1A) containing titanium oxide nanoparticles (mean particle size: 20 nm). The results are shown in FIG. 3.
As shown in FIG. 3, the hollow spheres obtained in Example 1 exhibits a much higher degree of light scattering than the conventional titanium oxide nanoparticles, and produces a light scattering effect similar to that of the titanium oxide nanoparticles prepared in Comparative Example 4.

Test Example 3

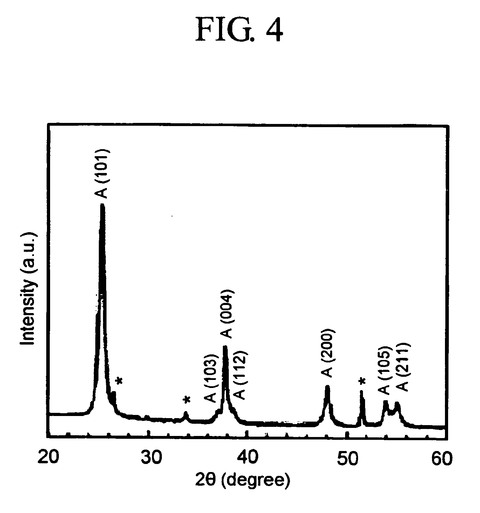

The structural properties of the hollow spheres were investigated using X-ray diffraction. FIG. 4 shows an X-ray diffraction scan obtained for the hollow spheres in accordance with one embodiment of the invention.
As shown in FIG 4, the diffraction peaks shown in FIG 4 match anatase phase of the crystalline titania. The matching peaks are denoted by A." In this figure, the peaks denoted by "*" are attributed to the substrate.

Test Example 4

The open circuit voltage, photocurrent density, energy conversion efficiency and fill factor of each of the dye-sensitized solar cells obtained in Example 1 and Comparative Examples 1 to 4 were measured as described below. The results are shown in Tables 1 and 2.

(1) Open Circuit voltage (V) and Photocurrent Density (mA/cm$^2$) The open circuit voltage and photocurrent density were measured using Keithley SMU2400.
(2) Energy Conversion Efficiency and Fill Factor (%)

The energy conversion efficiency was measured using 1.5 AM, 100 mW/cm$^2$ solar simulator equipped with a xenon lamp (300 W, Oriel), AM 1.5 filter and Keithley SMU2400; and the fill factor was calculated from the energy conversion efficiency using the following equation:

$$Fill\ Factor(\%) = \frac{(J \times V)_{max}}{J_{SC} \times V_{OC}} \times 100$$

wherein J and V denote Y- and X-axis values of an energy conversion efficiency curve, respectively, and $J_{SC}$ and $V_{OC}$ denote Y- and X- axis intercept values, respectively.
The current-voltage characteristics were evaluated using a 100 mW/cm$^2$ xenon lamp as a light source for each dye-sensitized solar cell.

Table 1

|  | Photocurrent density (mA/cm$^2$) | Open voltage (mV) | Fill factor (%) | Energy conversion efficiency (%) |
|---|---|---|---|---|
| Comparative Example 1 | 9.1 | 882 | 69.2 | 5.51 |
| Comparative Example 2 | 0.65 | 817 | 54.3 | 0.29 |

As shown in Table 1, the dye-sensitized solar cell obtained in Comparative Example 1 exhibits a higher energy conversion efficiency than that obtained in Comparative Example 2.

Table 2

| | Photo-current density (mA/cm$^2$) | Open voltage (mV) | Fill factor (%) | Energy conversion efficiency (%) | Thickness ($\mu$m) |
|---|---|---|---|---|---|
| Comparative Example 3 | 12.5 | 857 | 72.8 | 7.79 | 6 |
| Comparative Example 4 | 14.6 | 849 | 72.1 | 8.96 | 12 |
| Example 1 | 16.6 | 823 | 71.0 | 9.67 | 16 |

As shown in Table 2, the dye-sensitized solar cell obtained in Example 1 exhibits a much higher energy conversion efficiency than those obtained in Comparative Examples 3 and 4.

Although the dye-sensitized solar cell prepared in Comparative Example 1 comprising the hollow spheres as a light absorbing layer has a good energy conversion efficiency, the dye-sensitized solar cell of Example 1 comprising the hollow spheres as a light scattering layer exhibits much better properties in terms of photocurrent density and the energy conversion efficiency.

Consequently, as can be seen from FIG 3, the hollow spheres employed as a light scattering layer exhibits markedly higher light scattering effect than the conventional titanium oxide nanoparticles, and it further functions as a photoelectron generating layer, which imparts markedly improved performance characteristics over conventional light scattering particles. Therefore, the dye-sensitized solar cell comprising the hollow spheres in the photo-electrode enhances the photoelectric conversion efficiency.

While the embodiments of the subject invention have been described and illustrated, it is obvious that various changes and modifications can be made therein without departing from the spirit of the present invention which should be limited only by the scope of the appended claims.

**Claims**

1. A photo-electrode for a dye-sensitized solar cell comprising:

   a conductive substrate;
   a light absorbing porous film comprising nanoparticles of a first metal oxide, which is formed on the conductive substrate;
   a light scattering porous film, which is formed on the light absorbing porous film; and
   a photosensitive dye adsorbed on the surface of the light absorbing metal oxide nanoparticles, **characterized in that** said light scattering porous film comprises hollow spherical agglomerates of nanoparticles of a second metal oxide and said photosensitive dye is adsorbed as well on the surface of the hollow spherical agglomerates of the light scattering porous film.

2. The photo-electrode of claim 1, wherein the first and second metal oxides are each independently selected from the group consisting of titanium (Ti) oxide, zirconium (Zr) oxide, Strontium (Sr) oxide, zinc (Zn) oxide, indium (In) oxide, lanthanum (La) oxide, vanadium (V) oxide, molybdenum (Mo) oxide, tungsten (W) oxide, tin (Sn) oxide, niobium (Nb) oxide, magnesium (Mg) oxide, aluminum (Al) oxide, yttrium (Y) oxide, scandium (Sc) oxide, samarium (Sm) oxide, gallium (Ga) oxide, strontium-titanium (SrTi) oxide, and a mixture thereof.

3. The photo-electrode of claim 1, wherein the light scattering porous film has an average thickness of 10 nm to 4 $\mu$m.

4. The photo-electrode of claim 1, wherein the metal oxide nanoparticles of the light scattering porous film have an average particle size of 1 to 500 nm.

5. The photo-electrode of claim 1, wherein the hollow spherical agglomerates have an average diameter ranging from 100 to 5,000 nm.

6. A process for preparing a photo-electrode for a dye-sensitized solar cell comprising:

(a) forming a light absorbing porous film comprising nanoparticles of a first metal oxide on the surface of a conductive Substrate;
(b) forming a light scattering porous film comprising hollow spherical agglomerates of nanoparticles of a second metal oxide on the light absorbing porous film; and
(c) depositing a photosensitive dye on the surfaces of the light absorbing porous film and the light scattering porous film using an adsorption method.

7. The process of claim 6, wherein the first and second metal oxides are each independently selected from the group consisting of titanium (Ti) oxide, zirconium (Zr) oxide, strontium (Sr) oxide, zinc (Zn) oxide, indium (In) oxide, lanthanum (La) oxide, vanadium (V) oxide, molybdenum (Mo) oxide, tungsten (W) oxide, tin (Sn) oxide, niobium (Nb) oxide, magnesium (Mg) oxide, aluminum (Al) oxide, yttrium (Y) oxide, scandium (Sc) oxide, samarium (Sm) oxide, gallium (Ga) oxide, strontium-titanium (SrTi) oxide, and a mixture thereof.

8. The process of claim 6, wherein step (a) comprises:

preparing a paste containing the first metal oxide nanoparticles, a polymer binder and an organic solvent;
applying the paste over the conductive substrate; and
subjecting the applied substrate to heat treatment.

9. The process of claim 6, wherein step (b) comprises:

preparing a paste containing the hollow spherical agglomerates of the second metal oxide nanoparticles, a polymer binder and an organic solvent;
applying the paste on the light absorbing porous film; and
subjecting the applied substrate to heat treatment.

10. The process of claim 8 or 9, wherein the heat treatment is conducted at a temperature of 400 to 550°C for a period of 10 to 120 minutes.

11. The process of claim 6, wherein step (c) comprises immersing the substrate having the light absorbing porous film and the light scattering porous film formed thereon in a solution containing a photosensitive dye, to allow the photosensitive dye to adsorb on the surfaces of the light absorbing porous film and the light scattering porous film.

12. A dye-sensitized solar cell comprising:

a photo-electrode in accordance with any one of claims 1 to 5;
a counter electrode disposed opposite to the photo-electrode; and
an electrolyte filled in the space between the photo-electrode and the counter electrode.


**Patentansprüche**

1. Photoelektrode für eine farbstoffsensibilisierte Solarzelle, umfassend:

ein leitfähiges Substrat;
einen lichtabsorbierenden porösen Film, der Nanopartikel eines ersten Metalloxids enthält und der auf dem leitfähigen Substrat ausgebildet ist;
einen lichtstreuenden porösen Film, der auf dem lichtabsorbierenden porösen Film ausgebildet ist; und
einen photosensitiven Farbstoff, der an der Oberfläche der lichtabsorbierenden Metalloxid-Nanopartikel adsorbiert ist,

**dadurch gekennzeichnet, dass**
der lichtstreuende poröse Film hohle sphärische Agglomerate aus Nanopartikeln eines zweiten Metalloxids enthält, und der photosensitive Farbstoff ebenfalls an der Oberfläche der hohlen sphärischen Agglomerate des lichtstreuenden porösen Films adsorbiert ist.

**2.** Photoelektrode nach Anspruch 1, wobei die ersten und zweiten Metalloxide jeweils unabhängig voneinander aus der Gruppe, umfassend Titan(Ti)-oxid, Zirkonium(Zr)-oxid, Strontium(Sr)-oxid, Zink(Zn)-oxid, Indium(In)-oxid, Lanthan(La)-oxid, Vanadium(V)-oxid, Molybdän(Mo)-oxid, Wolfram(W)-oxid, Zinn(Sn)-oxid, Niobium(Nb)-oxid, Magnesium(Mg)-oxid, Aluminium(Al)-oxid, Yttrium(Y)-oxid, Scandium(Sc)-oxid, Samarium(Sm)-oxid, Gallium(Ga)-oxid, Strontium-Titan(SrTi)-oxid und eine Mischung davon, ausgewählt sind.

**3.** Photoelektrode nach Anspruch 1, wobei der lichtstreuende poröse Film eine mittlere Dicke von 10 nm bis 4 $\mu$m aufweist.

**4.** Photoelektrode nach Anspruch 1, wobei die Metalloxid-Nanopartikel des lichtstreuenden porösen Films eine mittlere Partikelgröße von 1 bis 500 nm aufweisen.

**5.** Photoelektrode nach Anspruch 1, wobei die hohlen sphärischen Agglomerate einen mittleren Durchmesser von 100 bis 5.000 nm aufweisen.

**6.** Verfahren zur Herstellung einer Photoelektrode für eine farbstoffsensibilisierte Solarzelle, umfassend:

(a) Ausbildung eines lichtabsorbierenden porösen Films, der Nanopartikel eines ersten Metalloxids enthält, auf der Oberfläche eines leitfähigen Substrats;
(b) Ausbildung eines lichtstreuenden porösen Films, der hohle sphärische Agglomerate aus den Nanopartikeln eines zweiten Metalloxids enthält, auf dem lichtabsorbierenden porösen Film; und
(a) Abscheidung eines photosensitiven Farbstoffs auf der Oberfläche des lichtabsorbierenden porösen Films und des lichtstreuenden porösen Films unter Verwendung eines Adsorptionsverfahrens.

**7.** Verfahren nach Anspruch 6, wobei die ersten und zweiten Metalloxide jeweils unabhängig voneinander aus der Gruppe, umfassend Titan(Ti)-oxid, Zirkonium(Zr)-oxid, Strontium(Sr)-oxid, Zink(Zn)-oxid, Indium(In)-oxid, Lanthan(La)-oxid, Vanadium(V)-oxid, Molybdän(Mo)-oxid, Wolfram(W)-oxid, Zinn(Sn)-oxid, Niobium(Nb)-oxid, Magnesium(Mg)-oxid, Aluminium(Al)-oxid, Yttrium(Y)-oxid, Scandium(Sc)-oxid, Samarium(Sm)-oxid, Gallium(Ga)-oxid, Strontium-Titan(SrTi)-oxid und eine Mischung davon, ausgewählt sind.

**8.** Verfahren nach Anspruch 6, wobei Schritt (a) Folgendes umfasst:

Herstellung einer Paste, die die ersten Metalloxid-Nanopartikel, ein Polymer-Bindemittel und ein organisches Lösungsmittel enthält;
Auftragen der Paste auf das leitfähige Substrat; und
Unterwerfen des aufgetragenen Substrats einer Wärmebehandlung.

**9.** Verfahren nach Anspruch 6, wobei Schritt (b) Folgendes umfasst:

Herstellung einer Paste, die die hohlen sphärischen Agglomerate aus den zweiten Metalloxid-Nanopartikeln, ein Polymer-Bindemittel und ein organisches Lösungsmittel enthält;
Auftragen der Paste auf den lichtabsorbierenden porösen Film; und
Unterwerfen des aufgetragenen Substrats einer Wärmebehandlung.

**10.** Verfahren nach Anspruch 8 oder 9, wobei die Wärmebehandlung bei einer Temperatur von 400 bis 550°C für eine Dauer von 10 bis 120 Minuten durchgeführt wird.

**11.** Verfahren nach Anspruch 6, wobei Schritt (c) das Eintauchen des Substrats, das den lichtabsorbierenden porösen Film und den darauf ausgebildeten lichtstreuenden porösen Film aufweist, in eine Lösung, die einen photosensitiven Farbstoff enthält, so dass der photosensitive Farbstoff an der Oberfläche des lichtabsorbierenden porösen Films und des lichtstreuenden porösen Films adsorbieren kann.

**12.** Farbstoffsensibilisierte Solarzelle, umfassend:

eine Photoelektrode nach einem der Ansprüche 1 bis 5;
eine Gegenelektrode, die gegenüberliegend der Photoelektrode angeordnet ist; und
ein Elektrolyt, das in den Raum zwischen der Photoelektrode und der Gegenelektrode eingefüllt ist.

**Revendications**

1. Photoélectrode pour une cellule solaire sensibilisée par un colorant, comprenant:

   un substrat conducteur;
   un film poreux absorbant la lumière, comprenant des nanoparticules d'un premier oxyde métallique, qui est formé sur le substrat conducteur;
   un film poreux dispersant la lumière qui est formé sur le film poreux absorbant la lumière; et
   un colorant photosensible étant adsorbé à la surface des nanoparticules de l'oxyde métallique absorbant la lumière, **caractérisé en ce que** le film poreux dispersant la lumière comprend des agglomérats sphériques creux des nanoparticules d'un second oxyde métallique, et ledit colorant photosensible étant également adsorbé à la surface des agglomérats sphériques creux du film poreux dispersant la lumière.

2. Photoélectrode selon la revendication 1, dans lequel les premiers et les seconds oxydes métalliques sont chacun sélectionnés indépendamment dans le groupe consistant en oxyde de titane (Ti), oxyde de zirconium (Zr), oxyde de strontium (Sr), oxyde de zinc (Zn), oxyde d'indium (In), oxyde de lanthane (La), oxyde de vanadium (Va), oxyde de molybdène (Mo), oxyde de tungstène (W), oxyde d'étain (Sn), oxyde de niobium (Nb), oxyde de magnésium (Mg), oxyde d'aluminium (Al), oxyde d'yttrium (Y), oxyde de scandium (Sc), oxyde de samarium (Sm), oxyde de gallium (Ga), oxyde de strontium-titane (SrTi) et un mélange de ceux-ci.

3. Photoélectrode selon la revendication 1, dans lequel le film poreux dispersant la lumière présente une épaisseur moyenne de 10 nm à 4 $\mu$m.

4. Photoélectrode selon la revendication 1, dans lequel les nanoparticules de l'oxyde métallique du film poreux dispersant la lumière présentent une taille moyenne des particules allant de 1 à 500 nm.

5. Photoélectrode selon la revendication 1, dans lequel les agglomérats sphériques creux présentent un diamètre moyen allant de 100 à 5,000 nm.

6. Procédé pour la préparation d'une photoélectrode pour une cellule solaire sensibilisée par un colorant comprenant:

   (a) formation d'un film poreux absorbant la lumière, comprenant des nanoparticules d'un premier oxyde métallique, sur la surface d'un substrat conducteur;
   (b) formation d'un film poreux dispersant la lumière, comprenant des agglomérats sphériques creux des nanoparticules d'un second oxyde métallique, sur le film poreux absorbant la lumière; et
   (c) dépôt d'un colorant photosensible sur la surface du film poreux absorbant la lumière et sur la surface du film poreux dispersant la lumière en utilisant un procédé d'adsorption.

7. Procédé selon la revendication 6, dans lequel les premiers et les seconds oxydes métalliques sont chacun sélectionnés indépendamment dans le groupe consistant en oxyde de titane (Ti), oxyde de zirconium (Zr), oxyde de strontium (Sr), oxyde de zinc (Zn), oxyde d'indium (In), oxyde de lanthane (La), oxyde de vanadium (Va), oxyde de molybdène (Mo), oxyde de tungstène (W), oxyde d'étain (Sn), oxyde de niobium (Nb), oxyde de magnésium (Mg), oxyde d'aluminium (Al), oxyde d'yttrium (Y), oxyde de scandium (Sc), oxyde de samarium (Sm), oxyde de gallium (Ga), oxyde de strontium-titane (SrTi) et un mélange de ceux-ci.

8. Procédé selon la revendication 6, dans lequel l'étape (a) consiste à:

   préparer une pâte contenant les premiers nanoparticules de l'oxyde métallique,
   un liant polymère et un solvant organique;
   appliquer la pâte sur le substrat conducteur; et
   soumettre le substrat appliqué à un traitement thermique.

9. Procédé selon la revendication 6, dans lequel l'étape (b) consiste à:

   préparer une pâte contenant les agglomérats sphériques creux des nanoparticules du second oxyde métallique,
   un liant polymère et un solvant organique;
   appliquer la pâte sur le film poreux absorbant la lumière; et
   soumettre le substrat appliqué à un traitement thermique.

**10.** Procédé selon les revendications 8 ou 9, dans lequel le traitement thermique est effectué à une température de 400 à 500°C pour une durée de 10 à 120 minutes.

**11.** Procédé selon la revendication 6, dans lequel l'étape (c) comprend l'immersion du substrat présentant le film poreux absorbant la lumière et le film poreux dispersant la lumière étant formé sur celui-ci dans une solution contenant un colorant photosensible, afin de permettre le colorant photosensible de s'adsorber à la surface du film poreux absorbant la lumière et à la surface du film poreux dispersant la lumière.

**12.** Cellule solaire sensibilisée par un colorant, comprenant:

une photoélectrode selon une quelconque des revendications 1 à 5;
une contre-électrode étant disposée de façon opposée à la photoélectrode; et
un électrolyte étant versé dans l'espace entre la photoélectrode et la contre-électrode.

# FIG. 1A

# FIG. 1B

# FIG. 1C

# FIG. 2A

# FIG. 2B

# FIG. 3

# FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040226602 A1
- JP 2001076772 A
- KR 0575843
- KR 100575843